# EUROPEAN PATENT SPECIFICATION

(11) **EP 2 666 186 B1**
(45) Date of publication and mention of the grant of the patent: **04.03.2015**
(21) Application number: 12816422.5
(22) Date of filing: 30.12.2012
(51) Int. Cl.: H01L 27/15

(54) **LIGHT EMITTING DEVICES**
LICHTEMITTIERENDE VORRICHTUNGEN
DISPOSITIFS ÉMETTEURS DE LUMIÈRE

(30) Priority: 30.12.2011 US 201161581984 P; 03.04.2012 US 201261619838 P
(43) Date of publication of application: 27.11.2013
(73) Proprietor: Purelux Inc., Charlotte, NC 28209 (US)
(72) Inventor: RYDEN, Carl, Cary, NC 27511 (US)
(74) Representative: Phillips & Leigh
(86) International application number: PCT/US2012/072245
(87) International publication number: WO 2013/102178

(56) References cited:
- US-A- 6 100 103
- US-A1- 2009 078 955
- US-A1- 2009 114 931

## Description

### FIELD

The present invention relates to light emitting devices and, in particular, to semiconductor light emitting devices.

### BACKGROUND

Currently available lighting systems include incandescent, fluorescent, halogen, and high intensity discharge sources of light. Disadvantages exist within lighting systems based on these illumination sources, many related to efficiency. Presently, only about 30% of the electrical energy consumed in lighting applications results in the production of light. The remainder of the electrical energy is dissipated by non-radiative processes, such as heat generation. Incandescent light sources, for example, consume 45% of all lighting energy but only produce 14% of the total light generated. Moreover, fluorescent lamps are only about four times as efficient as incandescent sources and still suffer from inherent energy loss.

New lighting technologies are being developed in efforts to overcome the disadvantages of present lighting systems. One such technology involves light emitting diodes (LEDs). In general, a light emitting diode is based on a forward biased p-n junction. Depending on the materials used to construct the p-n junction, the emitted radiation can fall within the ultraviolet, visible or infrared regions of the electromagnetic spectrum. Light emitting diodes offer the advantages of enhanced lifetimes, reduced heat production, and rapid illumination times.

However, current light emitting diodes have several disadvantages including temperature dependent performance characteristics, unidirectional light output and narrow emission bands. The narrow emission characteristics of light emitting diodes require bundling of several diodes of varying color to produce a white light source. Alternatively, downconverting phosphors have been used in conjunction with light emitting diodes for the production of a white light source. Bundling light emitting diodes and/or the use of phosphors is expensive and cost prohibitive for many applications. Moreover, current light emitting diodes are restricted to specific architectures foreclosing the development light emitting structures that can address one or more of the foregoing disadvantages.

US 2009/078955 discloses semiconductor micro-emitter arrays in which, in some embodiments, a light emitting device comprising one or more p-type layered assemblies alternating with one or more n-type layered assemblies in a stacked configuration.

### SUMMARY

The scope of the invention is as set out in the appended claims.

The inventive and other embodiments are described in greater detail in the detailed description which follows.

### BRIEF DESCRIPTION OF THE DRAWINGS

Figure 1 is an elevation view of light emitting device according to an unclaimed embodiment described herein.
Figure 2 is a top plan view of a light emitting device according to an unclaimed embodiment described herein.
Figure 3 is a top plan view of a light emitting device according to an unclaimed embodiment described herein.
Figure 4 is an elevation view of light emitting device according to an unclaimed embodiment described herein.
Figure 5 is an elevation view of light emitting device according to an unclaimed embodiment described herein.
Figure 6 illustrates current flow modeling of an n-type layer in conjunction with a p-type layer according to an unclaimed embodiment described herein where electrons are injected from a cathodic contact normal to the p-n junction and holes are injected from an anodic contact normal to the p-n junction.
Figure 7 is an elevation view of light emitting device according to one embodiment of the invention described herein.
Figure 8 is a top plan view of a light emitting device according to one embodiment of the invention described herein.
Figure 9 is a top plan view of light emitting device according to one embodiment of the invention described herein.
Figure 10 illustrates light emission from a light emitting active layer at an integration time of 10 milliseconds according to one embodiment of the invention described herein.
Figure 11 illustrates light emission from a light emitting active layer at an integration time of 100 milliseconds according to one embodiment of the invention described herein.
Figure 12 illustrates light emission from a light emitting active layer at an integration time of 400 milliseconds according to one embodiment of the invention described herein.

### DETAILED DESCRIPTION

Embodiments described herein can be understood more readily by reference to the following detailed description and their previous and following descriptions. Elements, apparatus and methods described herein, however, are not limited to the specific embodiments presented in the detailed description. It should be recognized that these embodiments are merely illustrative of the principles of the present invention. Numerous modifications and adaptations will be readily apparent to those of skill in the art without departing for the scope of the invention.

### I. Light Emitting Devices

Light emitting devices are described herein which, in some embodiments, demonstrate architectures permitting structural modification for providing various light emission characteristics. In some embodiments, a light emitting device described herein comprises one or more p-type layered assemblies alternating with one or more n-type layered assemblies in a stacked configuration providing parallel or substantially parallel p-n junctions between the alternating p-type and n-type layered assemblies. One or more cathodic contacts are in electrical communication with the one or more n-type layered assemblies for electron injection therein, and one or more anodic contacts are in electrical communication with the one or more p-type layered assemblies for hole injection therein. Further, radiative electron-hole combination regions are proximate the p-n junctions formed by the alternating p-type and n-type assemblies. The alternating p-type and n-type layered assemblies can be in a singular stacked vertical architecture. Further, by providing multiple light emitting regions proximate p-n junctions throughout the vertical architecture of the device, opportunities for various light emission characteristics from a single architecture are possible.

Parallel or substantially parallel p-n junctions of devices described herein, at a minimum, can be provided by sandwiching one assembly of a first polarity type between assemblies of the opposite polarity type to establish two parallel or substantially parallel p-n junctions. In one example, a p-type assembly is positioned between two n-type assemblies (i.e. n-p-n). Alternatively, an n-type assembly is positioned between two p-type assemblies (i.e. p-n-p) in the establishment of parallel p-n junctions. Further, a light emitting device described herein can comprise two or more n-type assemblies alternating with two or more p-type assemblies, without restriction on the total number of alternating p-type and n-type assemblies.

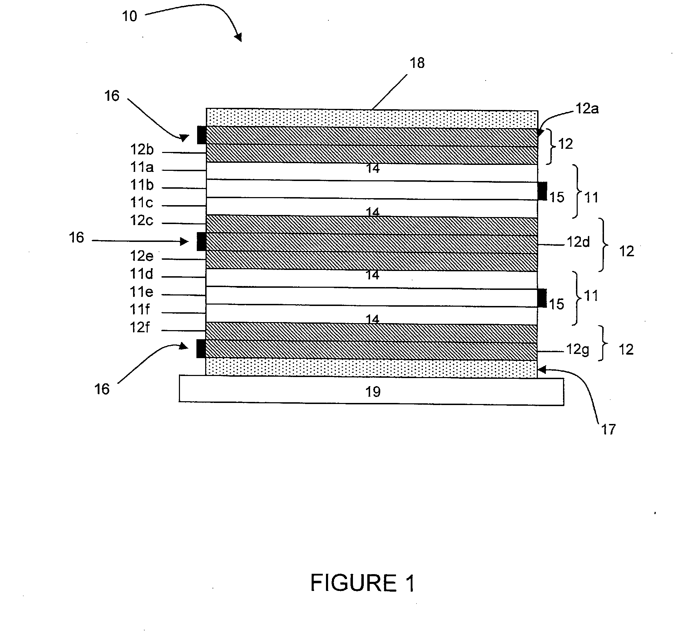

Figure 1 illustrates a light emitting device according to an unclaimed embodiment described herein. As illustrated in Figure 1, the light emitting device (10) comprises p-type layered assemblies (11) alternating with n-type layered assemblies (12) in a stacked configuration providing parallel or substantially parallel p-n junctions (14). A p-type layered assembly can comprise a single layer of p-doped semiconductor material or multiple layers of p-doped semiconductor material. In the unclaimed embodiment of Figure 1, the p-type layered assemblies (11) each comprise three layers of p-doped semiconductor material (e.g. 11a, 11b, 11c). Similarly, an n-type layered assembly can comprise a single layer of n-doped semiconductor material or multiple layers of n-doped semiconductor material. In the unclaimed embodiment of Figure 1, the n-type layered assemblies (12) can each comprise up to three layers of n-doped semiconductor material (e.g. 12c, 12d, 12e). As discussed further herein, the stacked architecture of alternating n-type assemblies (12) and p-type assemblies (11) can be epitaxially grown on a substrate (19). A buffer layer (17) can be positioned between the substrate (19) and the stacked architecture. Further, a capping layer (18) can be deposited over the stacked architecture.

Individual layers of a p-type assembly can demonstrate the same or differing constructions. For example, p-dopant levels of individual semiconductor layers forming a p-type assembly can be substantially the same. Alternatively, dopant levels of the p-type layers can be different, thereby establishing a dopant gradient in the assembly. In the unclaimed embodiment of Figure 1, for example, central layers (11b, 11e) of the p-type assemblies (11) comprise a p-dopant level at least an order of magnitude greater than adjacent layers (11a,c; 11d,f). Further, one or more layers of the p-type assembly can serve as a charge or current spreading layer to mitigate or inhibit current crowding adjacent to hole injection regions, thereby facilitating more uniform distributions of radiative combination events along p-n junctions formed by the alternating p-type and n-type assemblies. In the unclaimed embodiment of Figure 1, anodic contacts (15) are in electrical communication with highly doped central layers (11b,e), wherein central layers (11b,e) serve as current spreading layers of the p-type assemblies (11).

Similarly, individual layers of an n-type layered assembly can demonstrate the same or differing constructions. For example, n-dopant levels of individual semiconductor layers forming an n-type assembly can be substantially the same. Alternatively, dopant levels of the n-type layers can be different, thereby establishing a dopant gradient in the assembly. In some embodiments, for example, one or more layers of the n-type assembly can demonstrate substantially higher n-dopant levels than an adjacent layer. Further, one or more layers of the n-type assembly can serve as a charge or current spreading layer to mitigate or inhibit current crowding adjacent to electron injection regions, thereby facilitating more uniform distributions of radiative combination events along p-n junctions formed by the alternating p-type and n-type assemblies. In the unclaimed embodiment of Figure 1, cathodic contacts (16) are in electrical communication with layers (12a,d,g), wherein layers (12a,d,g) serve as current spreading layers of the n-type assemblies (12).

As illustrated in Figure 1, anodic (15) and cathodic (16) contacts demonstrate a lateral arrangement relative to the alternating p-type (11) and n-type (12) layered assemblies. In having a lateral arrangement, anodic (15) and cathodic (16) contacts do not participate as individual layers in the vertical light emitting structure provided by the alternating p-type (11)and n-type layered (12) assemblies. Therefore, lateral placement of anodic (15) and cathodic (16) contacts can permit maximum surface area for light emission from top and/or bottom surfaces of the stacked architecture. Further, the lateral placement of the anodic (15) and cathodic (16) contacts can result in carriers traveling parallel or substantially parallel to p-n junctions for a distance prior to radiative combination.

In the unclaimed embodiment of Figure 1, individual anodic contacts (15) are in electrical communication with central layers (11b,e) of the p-type assemblies (11) and individual cathodic contacts are in electrical communication with central layers (12a,d,g) of the n-type assemblies (12). Electrical leads can be used to place the anodic (15) and cathodic contacts (16) in communication with a voltage source (not shown). As discussed further herein, use of individual anodic and cathodic contacts can permit selective operation of individual p-type assemblies and n-type assemblies of a light emitting device. In some examples adjacent p-type and n-type layered assemblies of a light emitting device providing a junction with the desired emission profile can be selectively activated with holes and electrons for radiative combination, while the remaining p-type and n-type assemblies are inactive. As a result, the spectral output of the light emitting device can be varied according to which n-type and p-type assemblies are activated by the application of forward bias to selected cathodic and anodic contacts.

Individual anodic and cathodic contacts can be placed in electrical communication with p-type assemblies and n-type assemblies respectively by several methods leading to various contact architectures. As discussed further herein, peripheral areas and/or central areas of the stacked architecture can be selectively etched to expose portions of the desired layers for anodic and cathodic deposition. For example, in the unclaimed embodiment of Figure 1, the capping layer (18) can be selectively etched to expose a portion of layer (12a). A cathodic contact (16) is subsequently deposited on the exposed portion of layer (12a). A cathodic contact (16) for the next n-type assembly (12c-e) is provided by selectively etching a peripheral region of the stacked architecture to expose a portion of layer (12d). A cathodic contact (16) is subsequently deposited on the exposed portion of layer (12d). A cathodic contact (16) for the final n-type assembly (12f-g) of the light emitting device is provided by selectively etching a peripheral region of the stacked architecture to expose a portion of layer (12g). A cathodic contact (16) is subsequently deposited on the exposed portion of layer (12g).

Anodic contacts for the p-type layers assemblies can be fabricated in a similar fashion. For example, the stacked architecture of the light emitting device (10) is selectively etched to expose a portion of layer (11b) of the p-type assembly (11). An anodic contact (15) is subsequently deposited on the exposed portion of layer (11b). Selective etching of peripheral and/or central regions of the stacked architecture is repeated for the deposition of an anodic contact (15) on layer (11e) of the remaining p-type assembly (11d-f).

Etching the stacked architecture of the light emitting device for electrical contact deposition on layers of the p-type and n-type assemblies can result in a stair step structure. Further, selective etching of the stacked architecture for electrical contact deposition can be achieved with various masking, wet etch and/or dry etch techniques known to those of skill in the semiconductor processing industry. As described further herein, masking in connection with etch stop layers built into the stacked architecture at predetermined intervals can be used with acid etching processes for exposure of the desired n-type and p-type layers for electrical contact deposition.

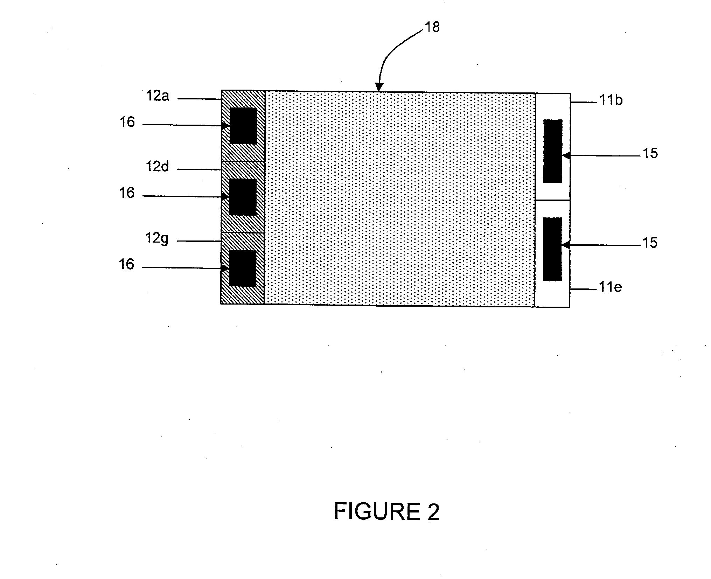

Figure 2 illustrates a top plan view of the light emitting device of Figure 1 according to one unclaimed embodiment. As illustrated in Figure 2, peripheral regions on opposing sides of the stacked architecture have been etched for the deposition of the anodic (15) and cathodic (16) contacts. Etching layers of the stacked architecture for contact deposition results in a stair step structure descending from layer (12a) to layer (12d) and finally to layer (12g) for the n-type assemblies. A similar stair step structure is provided for the p-type assemblies descending from layer (11b) to layer (11e).

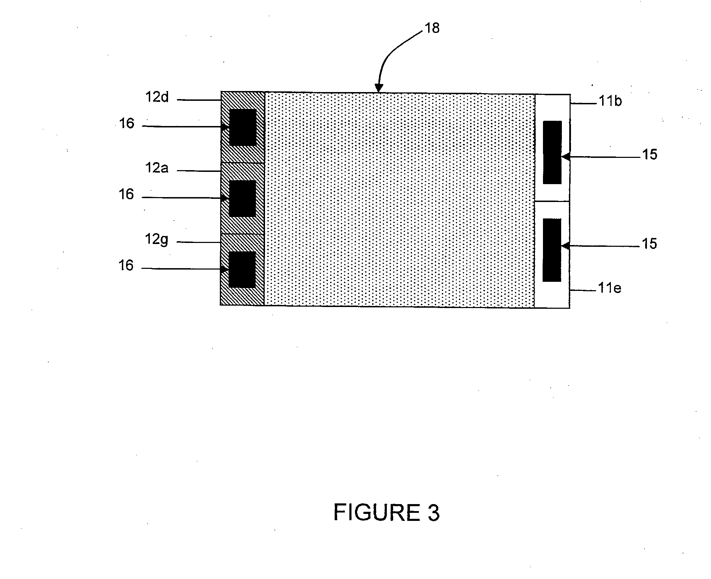

Further, Figure 3 is a top plan view of the light emitting device of Figure 1 according to another unclaimed embodiment. In the unclaimed embodiment of Figure 3, the stepped structures resulting from cathodic contact (16) deposition demonstrate a podium-style configuration with exposed layers (12d) and (12g) on either side of upper layer (12a). With anodic (15) and cathodic (16) contacts having a lateral arrangement outside the stacked architecture of the p-type (11) and n-type (12) assemblies, light emitting surface area of the device (10) is maximized. Further, the lateral arrangement of anodic (15) and cathodic (16) contacts can permit lateral flow of injected carriers prior to radiative combination of the carriers.

In some examples, a central region of the stacked architecture can be etched for the deposition of one or more anodic and/or cathodic contacts. Anodic and/or cathodic contacts deposited by etching of central regions of the stacked architecture can maintain a lateral arrangement relative to the stacked p-type and n-type assemblies, as one or more interior sides are produced by the central etching. Further, central etching can divide the singular stacked architecture into multiple discrete stacks having light emitting operability as described herein. As a result, central etching can provide multiple light emitting stacked architectures on a single wafer.

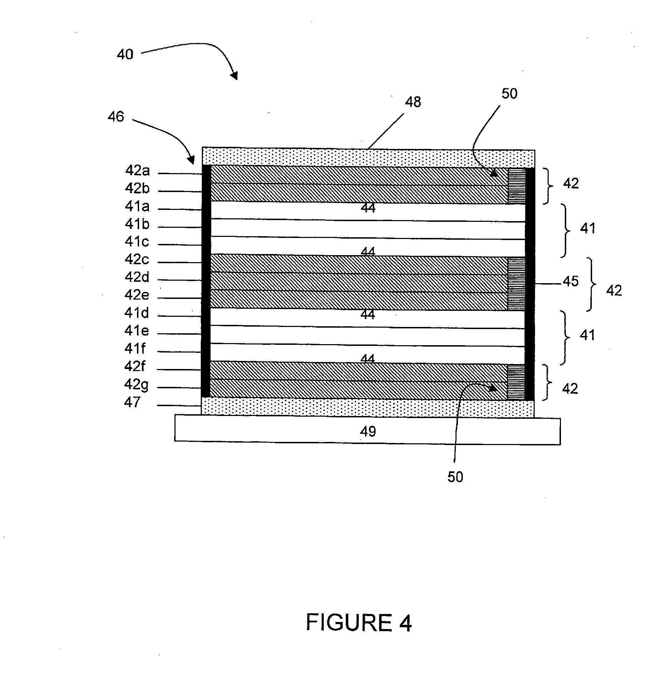

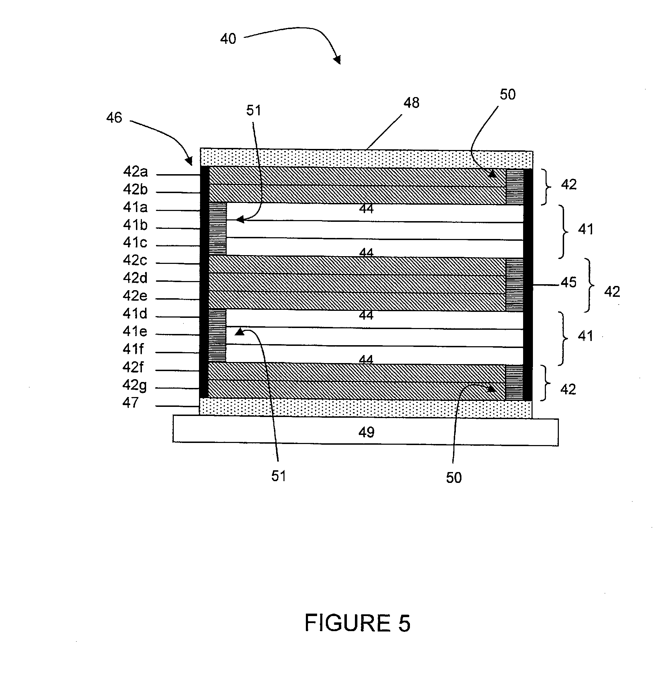

In alternative examples, n-type layered assemblies can be in electrical communication with a singular cathode, and p-type layered assemblies can be in electrical communication with a singular anode. Figure 4 illustrates a light emitting device having singular anode and cathode constructions. As illustrated in Figure 4, the light emitting device (40) comprises p-type layered assemblies (41) alternating with n-type layered assemblies (42) in a stacked configuration providing parallel or substantially parallel p-n junctions (44). In the unclaimed embodiment of Figure 4, the p-type layered assemblies (41) each comprise three layers of p-doped semiconductor material (e.g. 41a, 41b, 41c). Similarly, the n-type layered assemblies (42) can each comprise up to three layers of n-doped semiconductor material (e.g. 42c, 42d, 42e). A singular anodic contact (45) is positioned normal to the p-n junctions (44) and is in electrical communication with each of the p-type layered assemblies (41) for hole injection. Electrical barriers (50) are provided between the anodic contact (45) and the n-type layered assemblies (42). A singular cathodic contact (46) is also positioned normal to the p-n junctions (44) and is in electrical communication with the n-type layered assemblies. The cathodic contact (46) spans the p-n junctions and also contacts p-type layered assemblies (41). In some examples, electrical barriers (51) are also provided between the cathodic contact and the p-type assemblies. Such examples are illustrated in Figure 5.

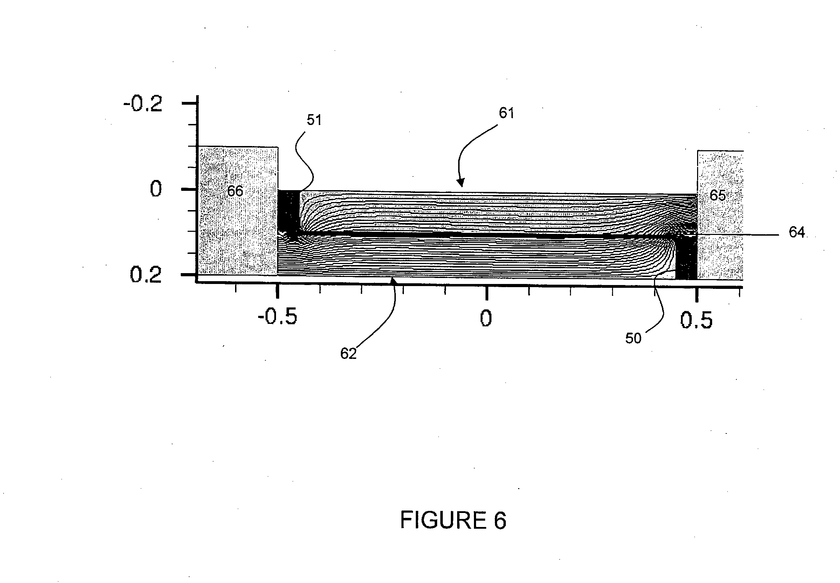

In the unclaimed embodiments of Figures 4 and 5, the lateral arrangement of the anodic and cathodic contacts is maintained, thereby permitting injected carriers to travel a distance parallel or substantially parallel to the p-n junction prior to radiative recombination. Figure 6 illustrates current flow modeling of an n-type layer (62) in conjunction with a p-type layer (61) according to one unclaimed embodiment described herein where electrons are injected from a lateral cathodic contact (66) normal to the p-n junction and holes are injected from a lateral anodic contact (65) normal to the p-n junction. As illustrated in Figure 6, the current flow is substantially parallel to the p-n junction (64) over a length of the junction (64) when a forward bias is applied to the cathodic contact (66) and the anodic contact (65).

Further, in some examples, n-type layered assemblies can be in electrical communication with a singular cathode as illustrated in Figures 4 and 5, while p-type layered assemblies are in electrical communication with individual anodic contacts as illustrated in Figure 1. In such examples, a side of the light emitting device corresponding to deposition of the anodic contacts can demonstrate a stepped structure while a side of the device having the singular cathode deposited thereon is not stepped. Additionally, p-type layered assemblies can be in electrical communication with a singular anode while n-type layered assemblies are in electrical communication with individual cathodic contacts as illustrated in Figure 1. In such examples, a side of the light emitting device corresponding to deposition of the cathodic contacts can demonstrate a stepped structure while a side of the device having the singular anode deposited thereon not stepped.

Turning now to specific structural components, a light emitting device described herein comprises n-type layered assemblies. An n-type assembly can comprise a single layer or multiple layers of n-type semiconductor material. Layers of n-type assemblies can comprise n-doped IIB/VIA (II/VI) semiconductor materials, n-doped IIIA/VA (III/V) semiconductor materials or n-doped Group IVA (Group IV) semiconductor materials or combinations thereof. Groups of the Periodic Table described herein are identified according to the CAS designation. In some examples, layer(s) of n-type assemblies comprise semiconductor alloys. For example, an n-type layer can comprise n-type ternary or quaternary semiconductor materials. In some examples, n-type layers comprise n-doped III/V ternary systems such as AlGaAs or InGaN. Additionally, n-type layers can comprise n-doped III/V quaternary systems such as AlGaInP, AlGaAsP or AlInGaAs. N-type layers, in some examples, comprise n-type I/III/VI systems, such as CuInGaSe.

An n-doped Group IV semiconductor material can comprise donor atoms (n-dopant) selected from one or more elements of Group VA of the Periodic Table including, but not limited to, antimony, arsenic, or phosphorus. An n-doped III/V semiconductor material can comprise donor atoms selected from one or more elements of Groups IVA and VIA of the Periodic Table. In some examples, for example, an n-dopant for III/V semiconductor material comprises sulfur, selenium, tellurium, silicon or germanium.

A layer of an n-type assembly can comprise any desired level of n-dopant not inconsistent with the objectives of the present invention. In some examples, an n-type layer has a doping level of at least about 10¹⁶ atoms/cm³. An n-type layer, in some embodiments, has a doping level ranging from about 10¹⁶ atoms/cm³ to about 10¹⁸ atoms/cm³. In some examples, an n-type layer has a doping level greater than about 10¹⁸ atoms/cm³. In embodiments where an n-type assembly comprises multiple n-type layers, the, dopant levels of the n-type layers are different, thereby establishing a dopant gradient in the assembly. In some embodiments, for example, one or more layers of an n-type assembly are used as current spreading layers.

A layer of an n-type assembly can have any thickness not inconsistent with the objectives of the present invention. In some examples, a layer of an n-type assembly has a thickness of 50 nm to 2 µm. In some examples, a layer of an n-type assembly has a thickness of 100 nm to 500 nm or 100 nm to 250 nm.

Moreover, a p-type assembly of a light emitting device described herein can comprise a single layer or multiple layers of p-type semiconductor material. Layers of p-type assemblies can comprise p-doped II/VI semiconductor materials, p-doped III/V semiconductor materials or p-doped group IV semiconductor materials or combinations thereof. In some examples, p-type layers comprise semiconductor alloys. In some examples, layer(s) of p-type assemblies comprise p-type ternary or quaternary semiconductor materials. For example, p-type layers can comprise p-doped III/V ternary systems such as AlGaAs or InGaN. In some examples, p-type layers comprise p-doped III/V quaternary systems such as AlGaInP, AlGaAsP or AlInGaAs. P-type layers can also comprise p-type I/III/VI systems, such as CuInGaSe.

A p-doped group IV semiconductor material, in some examples, comprises acceptor atoms (p-dopant) selected from one or more elements of groups IIIA of the Periodic Table including, but not limited to, boron, aluminum or gallium. In some examples, a p-doped III/V semiconductor material comprises acceptor atoms selected from one or more elements of groups IIA, IIB and IVA of the Periodic Table. For example, a p-dopant for III/V semiconductor material can comprise beryllium, magnesium, zinc, cadmium, silicon or germanium. Moreover, a p-doped group II/VI semiconductor material can comprise acceptor atoms selected from one or more transition metal elements or rare earth metal elements.

A layer of a p-type assembly can comprise any desired level of p-dopant not inconsistent with the objectives of the present invention. In some examples, a p-type layer has a doping level of at least about 10¹⁶ atoms/cm³. A p-type layer, in some examples, has a doping level ranging from about 10¹⁶ atoms/cm³ to about 10¹⁸ atoms/cm³. In some examples, a p-type layer has a doping level greater than about 10¹⁸ atoms/cm³. In examples where a p-type assembly comprises multiple p-type layers, the p-type layers can demonstrate the same or substantially the same dopant level. Alternatively, dopant levels of the p-type layers can be different, thereby establishing a dopant gradient in the assembly. In some embodiments, for example, one or more layers of a p-type assembly are used as current spreading layers. Such layers can demonstrate higher dopant levels than adjacent p-type layer(s).

In some examples, an n-type layer and a p-type of a p-n junction are asymmetrically doped permitting the diode current to be dominated by electron current or hole current.

A layer of a p-type assembly can have any thickness not inconsistent with the objectives of the present invention. In some examples, a layer of a p-type assembly has a thickness of 50 nm to 2 µm. In some examples, a layer of a p-type assembly has a thickness of 100 nm to 1 µm or 100 nm to 750 nm.

In some examples, layers of p-type assemblies and n-type assemblies of a light emitting device described herein are single crystalline. In being single crystalline, the p-type layers and the n-type layers demonstrate epitaxial relationships. Alternatively, in some examples, the p-type layers and n-type layers are polycrystalline. Polycrystalline n-type layers and p-type layers, in some examples, demonstrate epitaxial relationships. In some examples, polycrystalline n-type layers and p-type layers do not display epitaxial relationships.

Further, in some examples of a light emitting device described herein, electrons of an n-doped semiconductor material have a different mobility than holes of the p-doped semiconductor material. In some examples, electrons of an n-doped semiconductor material have mobility greater than the holes of the p-doped semiconductor material. For example, electrons of an n-doped semiconductor material can have mobility one order of magnitude or two orders of magnitude greater than the mobility of the holes of the p-doped semiconductor material.

In some examples, the ratio of electron mobility in an n-type layer to hole mobility in a p-type layer of a light emitting device described herein is at least 2. In some examples, the ratio of electron mobility to hole mobility is at least 5 or at least 10. In some examples, the ratio of electron mobility to hole mobility is at least 50 or at least 100. In some examples, the ratio of electron mobility to hole mobility ranges from about 1.1 to about 50. In some examples, the ratio of electron mobility to hole mobility ranges from about 2 to about 30.

Alternatively, electrons of an n-type semiconductor material can have mobility less than holes of the p-type semiconductor material. In some examples, the ratio of electron mobility in an n-type layer to hole mobility in a p-type layer is less than 0.9. In some examples, the ratio of electron mobility to hole mobility is less than 0.5 or less than 0.1.

N-type layers and/or p-type layers of a light emitting device described herein can demonstrate compositional variances. In some examples, the compositional parameters of individual layers of p-type assemblies are varied to alter the bandgaps of the individual layers. In some examples, bandgaps of at least two p-type layers are different. Moreover, the compositional parameters of individual p-type layers can be varied to produce p-type layers proximate a light emitting surface having wider bandgaps than p-type layers distal to the light emitting surface. Further, the compositional parameters of individual p-type layers can be varied to alter the resistivities of the individual p-type layers or p-type assembly. In some examples, the resistivities of at least two p-type layers are different.

The compositional parameters of individual layers of n-type assemblies can also be varied to alter the bandgaps of the individual layers. In some examples, bandgaps of at least two n-type layers are different. The compositional parameters of individual n-type layers, in some examples, are varied to produce n-type layers proximate a light emitting surface having wider bandgaps than n-type layers distal to the light emitting surface. Additionally, the compositional parameters of individual n-type layers can be varied to alter the resistivities of the individual n-type layers. In some examples, the resistivities of at least two n-type layers are different.

In one non-limiting example, aluminum can be introduced into gallium arsenide (GaAs) p-type and/or n-type layers of the stacked architecture in differing amounts to increase the fraction of AlAs to GaAs, thereby varying the bandgap of the layers. In another non-limiting example, indium can be introduced into gallium nitride (GaN) in differing amounts to increase the fraction of InN to GaN, thereby varying the bandgap of the layers. Additionally, in some examples, different binary, ternary and/or quaternary semiconductor materials are used to construct the n-type layers and/or p-type layers. In some examples, n-type layers and/or p-type layers can be independently constructed of lattice matched or substantially lattice matched group IV semiconductor materials, III/V semiconductor material and/or II/VI semiconductor materials. In some examples, n-type layers and p-type layers of a light emitting device are independently constructed of semiconductor materials selected from the group consisting of AlAs, AlGaAs, GaAs, ZnS and ZnSe.

Varying the bandgap of n-type layers and/or p-type layers of a light emitting device having a stacked architecture described herein can permit the tailoring of light emission characteristics of the device. In some examples, the compositional parameters of individual n-type layers and/or p-type layers of a stacked light emitting device described herein can be selected to produce emission profiles that, when mixed or blended, result in white light or substantially white light emission from the singular device as determined according to the 1931 International Commission on Illumination (CIE) Chromaticity diagram. Such examples would preclude the need for the use of phosphors and/or LED bundling for the production of white light. Moreover, in some examples wherein cathodic contacts and/or anodic contacts are independently associated with individual n-type and/or p-type layers (e.g. Figures 1-3), the emission profile of the light emitting device can be altered depending on which n-type layers and p-type layers are activated by voltage application and/or the degree to which the n-type layers and p-type layers are activated. In some examples, for example, layers of each n-type assembly and each p-type assembly can be activated by application of voltage, wherein selected n-type and/or p-type layers are provided higher voltages than others to alter the emission profile of the light emitting device.

Moreover, thicknesses of individual n-type layers and/or p-type layers can be independently varied. In some examples, the thickness of an individual n-type layer and/or p-type layer can be determined or chosen according to the position of the layer in the light emitting device. In one example, narrow bandgap n-type layers and/or p-type layers distal from a light emitting surface of the device have thicknesses less than wider bandgap n-type layers and/or p-type layers proximate a light emitting surface. Such a thickness gradient may assist in mitigating self-absorption effects in the light emitting device. Further, thicknesses of individual n-type layers and/or p-type layers can be varied to alter series resistance of the device. Alteration of series resistance can affect light emission and thermal properties of the device.

Light emitting devices described herein can have any desired number of alternating p-type layered assemblies and n-type layered assemblies not inconsistent with the objectives of the present invention. In some examples, light emitting devices described herien comprise at least two n-type layered assemblies and at least 2 p-type layered assemblies in an alternating fashion.

In addition to alternating p-type layered assemblies and n-type layered assemblies, a light emitting device described herein comprises one or more cathodic contacts for electron injection into n-type layers of the n-type assemblies. In some examples, cathodic contacts are metal. Metals suitable for use as a cathodic contact, in some embodiments, comprise elemental metals, e.g., gold, copper, platinum, aluminum, etc., as well as metal alloys. Cathodic contacts, in some examples, are non-transmissive to visible radiation. Alternatively, in some examples, one or more cathodic contacts are radiation transmissive. For example, a radiation transmissive cathodic contact can comprise a radiation transmissive conducting oxide. Radiation transmissive conducting oxides, in some examples, comprise indium tin oxide (ITO), gallium indium tin oxide (GITO), zinc indium tin oxide (ZITO), indium antimony oxide (IAO) or antimony tin oxide (ATO).

A light emitting device described herein also comprises one or more anodic contacts for hole injection into the p-type layers of the p-type assemblies. In some examples, anodic contacts are metal. Metals suitable for use as an anodic contact, in some embodiments, comprise elemental metals, e.g., gold, copper, platinum, aluminum, etc., as well as metal alloys. Anodic contacts, in some examples, are non-transmissive to visible radiation. Alternatively, in some examples, one or more anodic contacts are radiation transmissive. For example, a radiation transmissive anodic contact can comprise a radiation transmissive conducting oxide, such as indium tin oxide (ITO), gallium indium tin oxide (GITO), zinc indium tin oxide (ZITO), indium antimony oxide (IAO) or antimony tin oxide (ATO).

As described herein, a cathodic contact, in some examples, can span a p-n junction and contact the p-layer of the junction. An electrical barrier, in some examples, is disposed between the cathodic contact and the p-type layer. An electrical barrier can comprise any material and/or structure that precludes or inhibits charge transfer between the cathodic contact and the p-type layer. In some examples, an electrical barrier comprises one or more electrically insulating materials, such as dielectric material(s). In some examples, an electrical barrier comprises one or more inorganic oxides, including silica, alumina, titania or zirconia or combinations thereof.

In some examples, an electrical barrier comprises comprise one or more dielectric polymeric materials. In some examples, dielectric polymeric materials suitable for use as an electrical barrier comprise fluorinated polymers such as polyvinylidene fluoride (PVDF), poly(vinyl fluoride) (PVF), polytetrafluoroethylene (PTFE), perfluoropropylene, polychlorotrifluoroethylene (PCTFE), or copolymers or combinations or mixtures thereof. In some examples, a dielectric polymeric material comprises polyacrylates including polyacrylic acid (PAA), poly(methacrylate) (PMA), poly(methylmethacrylate) (PMMA) or copolymers and combinations thereof. In some examples, a dielectric polymeric material comprises polyethylenes, polypropylenes, polystyrenes, poly(vinylchloride), polycarbonates, polyamides, polyimides, or copolymers and combinations thereof. Polymeric dielectric materials, according to examples described herein, contemplate any suitable molecular weight (Mw) and polydispersity as understood by one of skill in the art.

In some examples, an electrical barrier is derived from the electronic structure of the electrode/p-type material, such as a Schottky barrier or other potential barrier.

Additionally, an anodic contact, in some examples, can span a p-n junction and contact the n-type layer of the junction. An electrical barrier, in some examples, is disposed between the anodic contact and the n-type layer. Suitable electrical barriers can comprise any of the same type recited herein for the p-layer in conjunction with a cathodic contact.

A light emitting device described herein comprises one or more p-type layered assemblies alternating with one or more n-type layered assemblies in a stacked configuration and light emitting active layers positioned between the p-type and n-type layered assemblies, the light emitting active layers forming junctions with the p-type and n-type layered assemblies. In some examples, light emitting active layers form parallel or substantially parallel junctions with p-type and n-type layered assemblies. One or more cathodic contacts are in electrical communication with the one or more n-type layered assemblies for injection of electrons therein and one or more anodic contacts are in electrical communication with the one or more p-type layered assemblies for hole injection therein.

Light emitting active layers forming junctions with p-type and n-type layered assemblies of devices described herein, at a minimum, can be provided by positioning a first assembly of first polarity type between second assemblies of second polarity type in a stacked arrangement. Light emitting active layers are positioned on each side of the first assembly permitting junction formation with both the first and second assemblies. In one example, a p-type assembly is positioned between two n-type assemblies. Light emitting active layers (active) are positioned on both sides of the p-type assembly (i.e. n-active-p-active-n), thereby permitting each light emitting active layer to form junctions with the p-type and n-type assemblies. Alternatively, an n-type assembly is positioned between two p-type assemblies. Light emitting active layers (active) are positioned on both sides of the n-type assembly (i.e. p-active-n-active-p), thereby permitting each light emitting active layer to form junctions with the with the p-type and n-type assemblies. Further, a light emitting device described herein can comprise two or more n-type assemblies alternating with two or more p-type assemblies and light emitting active layers positioned there between without restriction on the total number of alternating p-type, n-type assemblies and light emitting active layers.

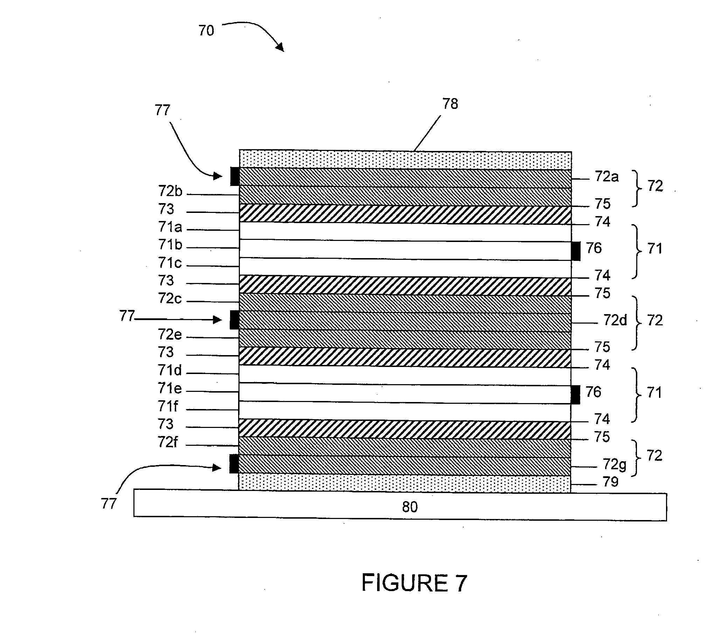

Figure 7 is an elevation view of a light emitting device according to one embodiment of the invention claimed and described herein. As illustrated in Figure 7, the light emitting device (70) comprises p-type layered assemblies (71) alternating with n-type layered assemblies (72). Light emitting active layers (73) are positioned between the p-type layered assemblies (71) and the n-type layered assemblies (72) forming parallel or substantially parallel junctions (74, 75) with the p-type (71) and n-type (72) layered assemblies. Further, the light emitting active layers (73) are spaced from one another by at least one n-type assembly (72) or at least one p-type assembly (71).

A p-type layered assembly can comprise a single layer of p-doped semiconductor material or multiple layers of p-doped semiconductor material. In the embodiment of Figure 7, the p-type layered assemblies (71) each comprise three layers of p-doped semiconductor material (e.g. 71a, 71b, 71c). Similarly, an n-type layered assembly can comprise a single layer of n-doped semiconductor material or multiple layers of n-doped semiconductor material. In the embodiment of Figure 7, the n-type layered assemblies can each comprise up to three layers of n-doped semiconductor material (e.g. 72c, 72d, 72e).

As described herein, individual p-type layers of a p-type assembly can demonstrate substantially the same p-dopant levels or different p-dopant levels. For example, in some embodiments, central layers (71b, 71e) of p-type assemblies (71) demonstrate higher p-dopant levels than adjacent p-type layers (71a,c; 71d,f). In such embodiments, central layers (71b, 71e) can serve as current spreading layers facilitating hole distribution to p-type layers (71a,c; 71d,f) cladding the active layers (73). Individual n-type layers of an n-type assembly demonstrate different n-dopant levels. For example, in some embodiments, layers (72a, 72d, 72g) of n-type assemblies (72) demonstrate higher n-dopant levels than adjacent n-type layers (72b; 72c,e; 72f). In such embodiments, layers (72a, 72d, 72g) can serve as current spreading layers facilitating electron distribution to n-type layers (72b; 72c,e; 72f) cladding the active layers (73).

Light emitting active layers (73) are positioned between the alternating p-type assemblies (71) and n-type assemblies (72). A light emitting active layer, therefore, forms a junction (74) with a p-type assembly and a junction (75) with an n-type assembly. The light emitting device (70) also comprises anodic contacts (76) in electrical communication with the p-type assemblies (71) and cathodic contacts (77) in electrical communication with the n-type assemblies (72). As illustrated in Figure 7, the anodic (76) and cathodic (77) contacts are provided a lateral orientation relative to the p-type (71) and n-type (72) assemblies. As a result, the anodic (76) and cathodic (77) contacts do not participate as individual layers in the stacked light emitting structure provided by the p-type assemblies (71), n-type assemblies (72) and light emitting layers (73). As described herein, the lateral or side placement of anodic (76) and cathodic (77) contacts can permit maximum surface area for light emission from the device (70). Additionally, lateral arrangement of the anodic (76) and cathodic (77) contacts can permit lateral flow of injected carriers prior to radiative combination in the light emitting layers (73).

In Figure 7, a buffer layer (79) can be positioned between the substrate (80) and the stacked architecture. Further, a capping layer (78) can be deposited over the stacked architecture.

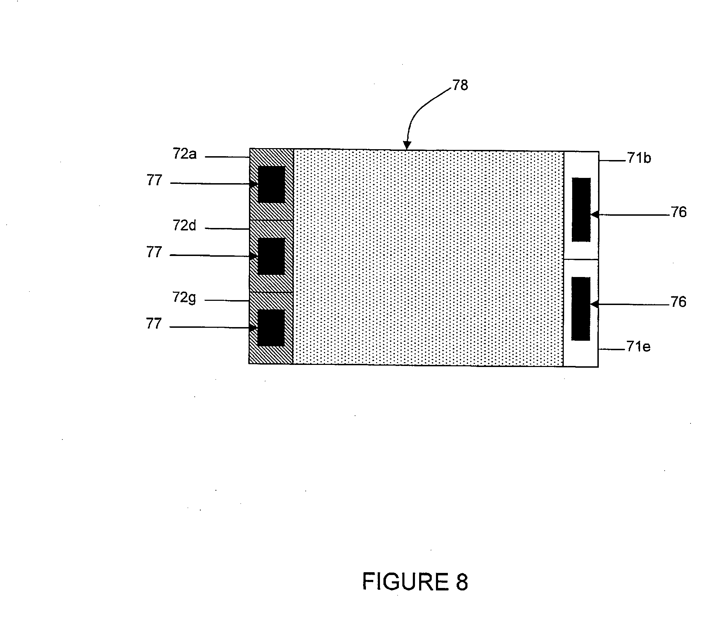

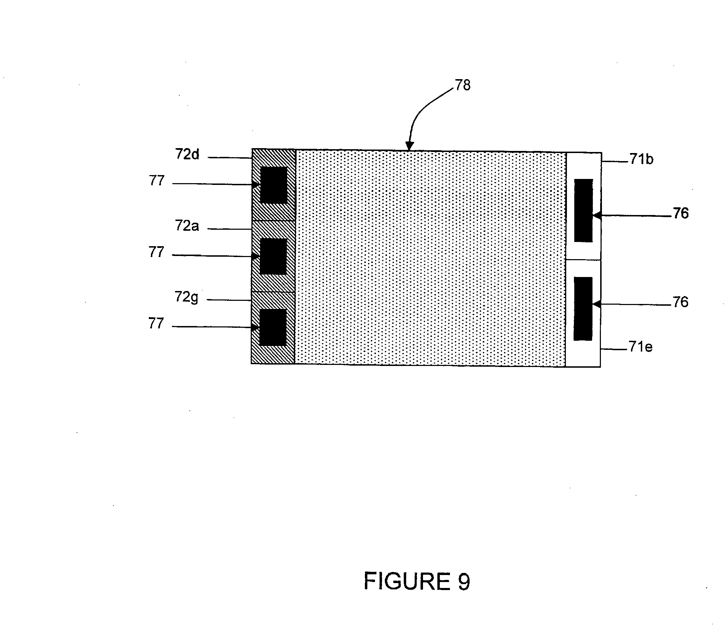

As illustrated in Figures 8 and 9, anodic (76) and cathodic (77) contacts of the light emitting device (70) demonstrate a stepped structure similar to that detailed in Figures 2 and 3 hereinabove. Stepped structures for electrode deposition can be fabricated by one or more selective etching techniques. In some examples, selective etching techniques employ masking followed by wet and/or dry etching. In some examples, etch stop layers are used in the electrode deposition process. Therefore, the stacked architecture of p-type (71) and n-type assemblies (72) can further comprise etch stop layers. In the embodiment of Figure 7, for example, etch stop layers can be disposed between layers (71a) and (71b), layers (72c) and (72d), layers (71d) and (71e) and layers (72f) and (72g).

In alternative examples, a singular anodic contact and singular cathodic contact can be used for carrier injection into the p-type assemblies and n-type assemblies respectively. For example, singular anodic and cathodic structures similar to those detailed in Figures 4 and 5 can be used with a light emitting device comprising light emitting active layers positioned between p-type layered assemblies and n-type layered assemblies. Electrically insulating layers can be used to isolate n-type assemblies and/or light emitting active layers from a singular anodic contact. Moreover, electrically insulating layers can be used to isolate p-type assemblies and/or light emitting active layers from a singular cathodic contact.

Further, a singular anodic contact can be used for the p-type assemblies and individual cathodic contacts in a stepped configuration can be used for the n-type assemblies. Conversely, in some examples, a singular cathodic contact can be used for the n-type assemblies and individual anodic contacts in a stepped configuration can be used for the p-type assemblies.

As described further herein, at least a portion of the electrons and holes injected into the n-type assemblies and p-type assemblies respectively are radiatively combined in the light emitting active layers. In some examples, the light emitting active layers have an electronic structure permitting or facilitating acceptance of electrons from the n-type assemblies and holes from the p-type assemblies. In some examples, light emitting active layers have a bandgap less than the adjacent p-type assemblies and n-type assemblies. For example, light emitting active layers can demonstrate a Type I bandedge line-up with the p-type assemblies and the n-type assemblies.

Light emitting active layers, in some examples, comprise a single quantum well structure in conjunction with the bounding p-type layered assemblies and n-type layered assemblies. In some examples, light emitting layers comprise multiple quantum well structures. Radiative recombination of holes and electrons can occur substantially uniformly along the length of a light active emitting layer. In some examples, radiative recombination of holes and electrons occurs non-uniformly along the length of a light emitting active layer. For example, radiative recombination of holes and electrons can be higher in region(s) of a light emitting layer proximate an anodic contact and/or cathodic contact in comparison with regions of the layer distal from the anodic and/or cathodic contact. In such examples, a radiative recombination gradient is established.

Light emitting active layers can comprise any semiconductor material not inconsistent with the objectives of the present invention. A light emitting active layer, in some examples, comprises a group IV semiconductor material, a III/V semiconductor material or a II/VI semiconductor material. The compositional identity of a light emitting active layer can be selected with reference to the compositional identities of the adjacent p-type layered assemblies and n-type layered assemblies. In some embodiments, light emitting active layers are undoped or intrinsic semiconductors resulting in p-i-n architectures when disposed between the p-type and n-type layered assemblies. Light emitting active layers, in some examples, are lightly n-doped or p-doped. In some examples, for example, a light emitting active layer demonstrates a p-dopant level less than a bordering p-type layer of a p-type assembly. Additionally, a light emitting active layer can demonstrate an n-dopant level less than a bordering n-type layer of an n-type assembly.

Light emitting active layers, in some examples, are single crystalline. In being single crystalline, light emitting active layers demonstrate epitaxial relationships with adjacent p-type and n-type layered assemblies. Alternatively, in some examples, light emitting active layers are polycrystalline. Polycrystalline light emitting active layers can also demonstrate epitaxial relationships with adjacent p-type and n-type layered assemblies. In some examples, polycrystalline light emitting active layers do not display epitaxial relationships with adjacent p-type and n-type assemblies.

As with n-type and p-type assemblies of a light emitting device described herein, light emitting active layers can display compositional variances. In some examples, the compositional parameters of individual light emitting active layers are varied to alter the bandgaps of the individual layers. In embodiments, of at least two light emitting layers are different. Additionally, the compositional parameters of an individual light emitting active layer can be varied according to position of the layer in the stacked architecture. In some examples, the compositional parameters of light emitting active layers proximate a light emitting surface are chosen to provide wider bandgaps than light emitting active layers distal to the light emitting surface.

In one non-limiting example, aluminum can be introduced into GaAs light emitting active layers in differing amounts to increase the fraction of AlAs to GaAs, thereby varying the bandgap of the light emitting layers. In another non-limiting example, indium can be introduced into GaN in differing amounts to increase the fraction of InN to GaN, thereby varying the bandgap of the light emitting active layers. In some examples, different binary, ternary and/or quaternary semiconductor materials are used to construct the light emitting active layers.

In some examples, light emitting active layers can be independently constructed of group IV semiconductor materials, III/V semiconductor materials and/or II/VI semiconductor materials lattice matched or substantially lattice matched to the adjacent p-type layered assemblies and n-type layered assemblies. For example, in some examples, light emitting active layers are independently constructed of semiconductor materials selected from the group consisting of AlAs, AlGaAs, GaAs, ZnS and/or ZnSe.

Varying the bandgap of light emitting active layers of a device described herein can permit the tailoring of light emission characteristics of the device. In some examples, the compositional parameters of the individual light emitting active layers can be selected to produce emission profiles that, when mixed or blended, result in white light or substantially white light emission from the device as determined according to the 1931 CIE chromaticity diagram. Such examples would preclude the need for the use of phosphors and/or LED bundling for the production of white light. Moreover, in some examples wherein cathodic contacts and/or anodic contacts are independently associated with individual n-type and/or p-type layered assemblies (e.g. Figure 7), the emission profile of the light emitting device can be altered depending on which light emitting active layers are activated by voltage application to selected contacts.

Light emitting active layers can have any desired thickness not inconsistent with the objectives of the present invention. In some examples, a light emitting active layer has a thickness ranging from about 20 nm to about 2 µm. A light emitting active layer, in some examples, has a thickness ranging from about 30 nm to about 750 nm. In some examples, a light emitting active layer has a thickness ranging from about 50 nm to about 250 nm. A light emitting active layer, in some examples, has a thickness ranging from about 5 nm to about 100 nm.

P-type and n-type layered assemblies used in conjunction with light emitting active layers can comprise any of the compositional parameters and properties recited herein for p-type and n-type layered assemblies. Moreover, anodic contacts, cathodic contacts and electrical barriers suitable for use with light emitting active layers can comprise any of the same recited hereinabove.

Light emitting devices having constructions described herein, in some examples are produced by chemical vapor deposition (CVD), including metal organic chemical vapor deposition (MOCVD). In some examples, light emitting devices described herein are produced by molecular beam epitaxy (MBE), atomic layer epitaxy (ALE) or solution atomic layer epitaxy (SALE). Cathodic and anodic contacts, in some examples**,** can be deposited by sputtering or thermal evaporation in conjunction with etching and/or lithographic masking techniques. As described herein, n-type layers, p-type layers and/or light emitting layers can be selectively etched for the deposition of cathodic contacts, anodic contacts and/or electrical barriers.

In some examples, light emitting devices having any of the constructions or architectures described herein demonstrate an internal quantum efficiency (IQE) of at least about 60% or at least about 70%. In some examples, light emitting devices described herein demonstrate an IQE of at least about 80%. Further, light emitting devices described herein, in some examples, are compatible with alternating current sources in addition to traditional direct current sources for diode operation.

### II. Methods of Emitting Light

Methods of emitting light are described herein. In some examples, a method for emitting light comprises providing a light emitting device comprising one or more p-type layered assemblies alternating with one or more n-type layered assemblies in a stacked configuration forming parallel or substantially parallel p-n junctions between the alternating p-type and n-type layered assemblies. One or more cathodic contacts are in electrical communication with the one or more n-type layered assemblies, and one or more anodic contacts are in electrical communication with the one or more p-type layered assemblies. A voltage is provided to the one or more cathodic contacts and the one or more anodic contacts to inject electrons into the one or more n-type layered assemblies and holes into the one or more p-type layered assemblies. At least a portion of the injected holes and electrons are radiatively combined in radiative electron-hole combination regions proximate the p-n junctions.

As described herein, radiative combination of carriers can be uniformly distributed along the length of the p-n junctions. In some examples, radiative recombination is non-uniformly distributed along the length of the p-n junctions. For example, radiative combination of holes and electrons can be higher in region(s) proximate an anodic contact and/or cathodic contact in comparison with region(s) distal from the anodic and/or cathodic contact.

In another example, a method of emitting light comprises providing a light emitting device comprising one or more p-type layered assemblies alternating with one or more n-type layered assemblies in a stacked configuration and light emitting active layers disposed between the alternating p-type and n-type layered assemblies, the light active emitting layers forming junctions with the p-type and n-type layered assemblies. One or more cathodic contacts are in electrical communication with the one or more n-type layered assemblies, and one or more anodic contacts are in electrical communication with the one or more p-type layered assemblies. A voltage is provided to the one or more cathodic contacts and the one or more anodic contacts to inject electrons into the one or more n-type layered assemblies and holes into the one or more p-type layered assemblies. At least a portion of the injected holes and electrons are radiatively recombined in the light emitting active layers.

Light emitting devices of the foregoing light emission methods can have any construction and/or properties recited in Section I hereinabove. In some examples, the light emitting devices demonstrate a construction as set forth in any of Figures 1-9 herein.

The invention is further illustrated by the following non-limiting example.

### EXAMPLE 1

### Light Emitting Device

A light emitting device having an architecture described herein was fabricated according to the parameters of Table I.

**Table I - Light Emitting Device Architecture**

| | Material | Atomic Percent (Al) | Type | Dopant | Hall Level (cm³) | Thickness (Angstrom) |
|---|---|---|---|---|---|---|
| 23 | GaAs | - | i | - | UID | 400-700 |
| 22 | AlₓGa₁₋ₓ As | 40.4 | N+ | Si | 9.6E+16 | 1800-2100 |
| 21 | AlₓGa₁₋ₓ As | 40.4 | N | Si | 9.6E+16 | 1300-1700 |
| 20 | AlₓGa₁₋ₓ As** | 35.4 | i | - | UID | 1000-1300 |
| 19 | AlₓGa₁₋ₓAs | 40.4 | P | Be | 1.0E+17 | 1300-1700 |
| 18 | AlAs* | - | i | - | UID | 20-30 |
| 17 | AlₓGa₁₋ₓAs | 40.4 | P+ | Be | 5.0E+18 | 6000-8000 |
| 16 | AlₓGa₁₋ₓ As | 40.4 | P | Be | 1.0E+17 | 1300-1700 |
| 15 | AlₓGa₁₋ₓ As** | 34.1 | i | - | UID | 900-1300 |
| 14 | AlₓGa₁₋ₓ As | 40.4 | N | Si | 9.6E+16 | 1300-1700 |
| 13 | AlAs* | - | i | - | UID | 20-30 |
| 12 | AlₓGa₁₋ₓ As | 40.4 | N+ | Si | 9.6E+16 | 3000-5000 |
| 11 | AlₓGa₁₋ₓ As | 40.4 | N | Si | 9.6E+16 | 1300-1700 |
| 10 | AlₓGa₁₋ₓ As** | 33.3 | i | - | UID | 900-1300 |
| 9 | AlₓGa₁₋ₓ As | 40.4 | P | Be | 1.0E+17 | 1300-1700 |
| 8 | AlAs* | - | i | - | UID | 20-30 |
| 7 | AlₓGa₁₋ₓ As | 40.4 | P+ | Be | 5.0E+18 | 6000-8000 |
| 6 | AlₓGa₁₋ₓ As | 40.4 | P | Be | 1.0E+17 | 1300-1700 |
| 5 | AlₓGa₁₋ₓ As** | 31.8 | i | - | UID | 900-1300 |
| 4 | AlₓGa₁₋ₓ As | 40.4 | N | Si | 9.6E+16 | 1300-1700 |
| 3 | AlAs* | - | i | - | UID | 20-30 |
| 2 | AlₓGa₁₋ₓ As | 40.4 | N+ | Si | 9.6E+16 | 1700-2200 |
| 1 | GaAs | - | i | | UID | 400-700 |
| | | | | | | |

| | | | | | | |
|---|---|---|---|---|---|---|
| *Etch Stop **Light Emitting Active Layer | | | | | | |

The epitaxially stacked structure detailed in Table I was fabricated by molecular beam epitaxy (MBE) at IQE, Inc. of Bethlehem, PA. The surface of the resulting structure was masked for selective etching to partially expose layer 22 of Table I for deposition of a cathodic contact. A solution of citric acid at 50 weight percent was used as the etching agent. The citric acid solution was prepared by dissolving 1:1 weight ratio of citric acid monohydrate with deionized water and stirring for 2 hours. The citric acid solution was mixed with hydrogen peroxide prior to application to the stacked architecture. Subsequent to etching, a cathodic contact was deposited on the exposed surface of layer 22 using an AuGe(500A)/Ni(250A)/Au(500A) contact system.

The surface of the stacked architecture was also masked for selective etching to partially expose layer 17 of Table I for deposition of an anodic contact. A citric acid solution as set forth above was used for the etching process. The stacked structure was etched with the citric acid solution to etch stop layer 18 of AlAs. The etch stop layer was subsequently removed with an dilute aqueous solution of HCl to expose P+ layer. Subsequent to etching, an anodic contact was deposited on the exposed surface of layer 17 using an AuGe(500A)/Ni(250A)/Au(500A) contact system.

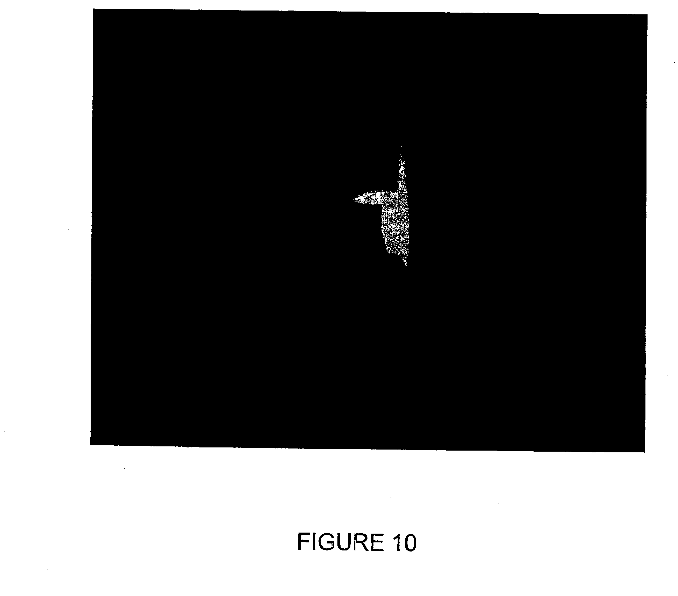

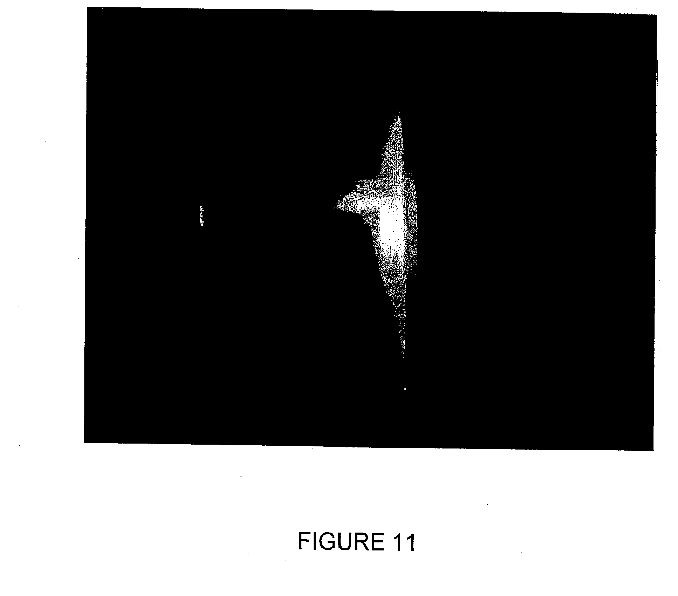

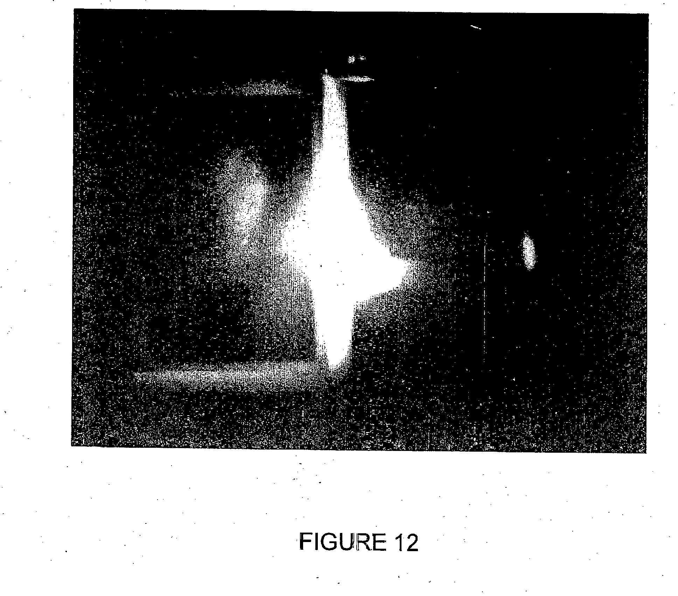

The light emitting device was subsequently biased through the deposited cathodic and anodic contacts to determine the light emitting functionality of active layer 20. Using the deposited anodic and cathodic contacts, the light emitting device was forward biased at 14V with current of 10 mA. Light emitting active layer 20 produced light visible to the naked eye under ambient room lighting conditions. Figures 10-12 illustrate light emission from active layer 22 at integration times of 10 milliseconds (ms), 100 ms and 400 ms.

Various embodiments of the invention have been described in fulfillment of the various objects of the invention. It should be recognized that these embodiments are merely illustrative of the principles of the present invention. Numerous modifications and adaptations thereof will be readily apparent to those skilled in the art without departing from the scope of the invention, which is defined by the appended claims.

## Claims

1. A light emitting device (70) comprising:
one or more p-type layered assemblies (71) alternating with one or more n-type layered assemblies (72) in a stacked configuration;
light emitting active layers (73) positioned between the p-type and the n-type layered assemblies (71,72), the light emitting active layers (73) forming junctions (74,75) with the p-type and n-type layered assemblies (71,72); and
one or more anodic contacts (76) in electrical communication with the one or more p-type layered assemblies (71) and one or more cathodic contacts (77) in electrical communication with the one or more n-type layered assemblies (72), wherein the anodic and cathodic contacts (76,77) have a lateral arrangement relative to the stacked p-type and n-type layered assemblies (71,72)
**characterised in that**,
the n-type layered assemblies (72) each comprise a plurality of layers (72a,72b; 72c,72d,72e; 72f,72g) of n-doped semiconductor material
and
one layer (72a,72d,72g) of n-doped semiconductor material has a higher level of n-dopant in comparison to an adjacent layer (72b; 72c, 72e; 72f) of n-doped semiconductor material.

2. A light emitting device (70) as claimed in Claim 1, wherein the anodic and cathodic contacts (76,77) are in a stepped configuration.

3. A light emitting device (70) as claimed in Claim 1, wherein the n-doped semiconductor material comprises n-doped III/V semiconductor material, n-doped II/VI semiconductor material or n-doped Group IV semiconductor material.

4. A light emitting device (70) as claimed in Claim 1, wherein the p-type layered assemblies (71) comprise a plurality of layers (71a,71b, 71c;71d,71e, 71f) of p-doped semiconductor material and wherein one layer (71b,71e) of p-doped semiconductor material has a higher level of p-dopant in comparison to an adjacent layer (71a,71c;71d,71f) of p-doped semiconductor material.

5. A light emitting device (70) as claimed in Claim 4, wherein the p-doped semiconductor material comprises p-doped III/V semiconductor material, p-doped II/VI semiconductor material or p-doped Group IV semiconductor material.

6. A light emitting device (70) as claimed in Claim 5, wherein the light emitting active layers (73) comprise intrinsic III/V semiconductor material, intrinsic II/VI semiconductor material or intrinsic Group IV semiconductor material.

7. A light emitting device (70) as claimed in Claim 6, wherein the p-type layered assemblies (71), n-type layered assemblies (72) and light emitting active layers (73) are epitaxial.

8. A light emitting device (70) as claimed in Claim 6, wherein the light emitting active layers (73) have different peak emission profiles.

9. A light emitting device (70) as claimed in Claim 1, wherein each n-type layered assembly (72) is in electrical communication with an independent cathodic contact (77) and each p-type layered assembly (71) is in electrical communication with an independent anodic contact (76).

10. A light emitting device (70) as claimed in Claim 1 further comprising one or more etch stop layers in the stacked configuration.

11. A light emitting device (70) as claimed in Claim 10, wherein the one or more etch stop layers are positioned in a p-type layered assembly (71) or n-type layered assembly (72).

12. A light emitting device (70) as claimed in Claim 1 which comprises two or more n-type assemblies (72) alternating with two or more p-type assemblies (71) with the light emitting active layers (73) positioned therebetween.

13. A light emitting device (70) as claimed in Claim 12, in which the p-type layered assemblies (71) each comprise three layers of p-doped semiconductor material (71a, 71b, 71c; 71d,71e,71f) and the n-type layered assemblies (72) each comprise up to three layers of n-doped semiconductor material (72c, 72d, 72e).

14. A light emitting device (70) as claimed in Claim 12 or Claim 13, in which the individual p-type layers (71a, 71b, 71c; 71d,71e,71f) of a p-type assembly (71) have different p-dopant levels.

15. A light emitting device (70) as claimed in Claim 4 or Claim 14, in which central layers (71b, 71e) of p-type assemblies (71) demonstrate higher p-dopant levels than adjacent p-type layers (71a,71c; 71d,71f).

## Patentansprüche

1. Eine Licht-emittierende Vorrichtung (70) enthaltend:
einen oder mehrere geschichtete p-leitende Anordnungen (71), die sich mit einer oder mehreren n-leitenden Anordnungen (72) in einer übereinander angeordneten Konfiguration abwechseln;
Licht-emittierende aktive Schichten (73), die zwischen p-leitenden und n-leitenden geschichteten Anordnungen (71, 72) positioniert sind, wobei die Licht-emittierenden aktiven Schichten (73) Übergänge (74, 75) mit den p-leitenden und den n-leitenden Anordnungen (71, 72) bilden; und
einen oder mehrere anodische Kontakte (76) in elektrischer Verbindung mit dem einen oder den mehreren p-leitenden geschichteten Anordnungen (71) und einen oder mehrere kathodische Kontakte (77) in elektrischer Verbindung mit dem einen oder den mehreren n-leitenden geschichteten Anordnungen (72), wobei die anodischen und die kathodischen Kontakte (76, 77) eine seitliche Anordnung bezogen auf die übereinander angeordneten p-leitenden und n-leitenden Anordnungen (71, 72) aufweisen,
**dadurch gekennzeichnet, dass**
die n-leitenden geschichteten Anordnungen (72) jeweils eine Vielzahl von Schichten (72a, 72b; 72c, 72d, 72e; 72f, 72g) von n-dotierten Halbleitermaterial aufweisen
und
eine Schicht (72a, 72d, 72g) des n-dotierten Halbleitermaterials einen höheren Gehalt an n-Dotierungsmittel im Vergleich zu einer benachbarten Schicht (72b; 72c, 72e; 72f) eines n-dotierten Halbleitermaterials aufweist.

2. Eine Licht-emittierende Vorrichtung (70) gemäß Anspruch 1, wobei die anodischen und die katodischen Kontakte (76, 77) in einer abgestuften Konfiguration vorliegen.

3. Eine Licht-emittierende Vorrichtung (70) gemäß Anspruch 1, wobei das n-dotierte Halbleitermaterial n-dotiertes Halbleitermaterial der Gruppe III/V, n-dotiertes Halbleitermaterial der Gruppe II/VI oder n-dotiertes Halbleitermaterial der Gruppe IV enthält.

4. Eine Licht-emittierende Vorrichtung (70) gemäß Anspruch 1, wobei die p-leitenden Anordnungen (71) eine Vielzahl von Schichten (71 a, 71 b, 71 c; 71 d, 71 e, 71 f) eines p-leitenden Halbleitermaterials aufweist und wobei eine Schicht (71 b, 71 e) eines p-dotierten Halbleitermaterials einen höheren Gehalt eines p-Dotierungsmittels im Vergleich zu einer benachbarten Schicht (71 a, 71 c; 71 d, 71 f) eines p-dotierten Halbleitermaterials aufweist.

5. Eine Licht-emittierende Vorrichtung (70) gemäß Anspruch 4, wobei das p-dotierte Halbleitermaterial p-dotiertes Halbleitermaterial der Gruppe III/V, p-dotiertes Halbleitermaterial der Gruppe II/VI oder p-dotiertes Halbleitermaterial der Gruppe IV aufweist.

6. Eine Licht-emittierende Vorrichtung (70) gemäß Anspruch 5, wobei die Licht-emittierenden aktiven Schichten (73) intrinsisches Halbleitermaterial der Gruppe III/V, intrinsisches Halbleitermaterial der Gruppe II/VI oder intrinsisches Halbleitermaterial der Gruppe IV aufweist.

7. Eine Licht-emittierende Vorrichtung (70) gemäß Anspruch 6, wobei die p-leitenden geschichteten Anordnungen (71), n-leitenden geschichteten Anordnungen (72) und die Licht-emittierenden aktiven Schichten (73) epitaktisch sind.

8. Eine Licht-emittierende Vorrichtung (70) gemäß Anspruch 6, wobei die Licht-emittierenden aktiven Schichten (73) unterschiedliche Emissionsmaxima-Profile aufweisen.

9. Eine Licht-emittierende Vorrichtung (70) gemäß Anspruch 1, wobei jede n-leitende geschichtete Anordnung (72) in elektrischer Verbindung mit einem unabhängigen kathodischen Kontakt (77) steht und jede p-leitende geschichtete Anordnung (71) in elektrischer Verbindung mit einem unabhängigen anodischen Kontakt (76) steht.

10. Eine Licht-emittierende Vorrichtung (70) gemäß Anspruch 1, weiterhin enthaltend eine oder mehrere Ätzstopp-Schichten in übereinanderliegender Weise.

11. Eine Licht-emittierende Vorrichtung (70) gemäß Anspruch 10, wobei die eine oder die mehreren Ätzstopp-Schichten in einer p-leitenden geschichteten Anordnung (71) oder n-leitenden geschichteten Anordnung (72) positioniert sind.

12. Eine Licht-emittierende Vorrichtung (70) gemäß Anspruch 1, enthaltend zwei oder mehrere n-leitende Anordnungen (72), die sich mit zwei oder mehr p-leitenden Anordnungen (71) mit dazwischen gelagerten Licht-emittierenden aktiven Schichten (73) abwechseln.

13. Eine Licht-emittierende Vorrichtung (70) gemäß Anspruch 12, wobei die p-leitende geschichtete Anordnungen (71) jeweils drei Schichten eines p-dotierten Halbleitermaterials (71 a, 71 b, 71 c; 71 d, 71 e, 71 f) aufweisen und die n-leitenden geschichteten Anordnungen (72) jeweils bis zu drei Schichten eines n-dotierten Halbleitermaterials (72c, 72d, 72e) aufweisen.

14. Eine Licht-emittierende Vorrichtung (70) gemäß Anspruch 12 oder 13, wobei die individuellen p-leitenden Schichten (71 a, 71 b, 71 c; 71 d, 71 e, 71 f) einer p-leitenden Anordnung (71) unterschiedliche Gehalte eines p-Dotierungsmittels aufweisen.

15. Eine Licht-emittierende Vorrichtung (70) gemäß Anspruch 4 oder 14, wobei die zentralen Schichten (71 b, 71 e) der p-leitenden Anordnungen (71) höhere Gehalte eines p-Dotierungsmittels zeigen als benachbarte p-leitende Schichten (71 a, 71 c; 71 d, 71 f).

## Revendications

1. Dispositif électroluminescent (70) comprenant :
un ou plusieurs ensembles en couches de type p (71) alternant avec un ou plusieurs ensembles en couches de type n (72) dans une configuration empilée ;
des couches actives électroluminescentes (3) positionnées entre les ensembles en couches de type p et de type n (71, 72), les couches actives électroluminescentes (73) formant des jonctions (74, 75) avec les ensembles en couches de type p et de type n (71, 72) ; et
un ou plusieurs contacts anodiques (76) en communication électrique avec les un ou plusieurs ensembles en couches de type p (71) et un ou plusieurs contacts cathodiques (77) en communication électrique avec les un ou plusieurs ensembles en couches de type n (72), dans lequel les contacts anodiques et cathodiques (76, 77) ont un agencement latéral par rapport aux ensembles en couches de type p et de type n empilés (71, 72)
**caractérisé en ce que**,
les ensembles en couches de type n (72) comprennent chacun une pluralité de couches (72a, 72b ; 72c, 72d, 72e ; 72f, 72g) d'un matériau semi-conducteur à dopage de type n et
une couche (72a, 72d, 72g) de matériau semi-conducteur à dopage de type n a un niveau plus élevé de dopant de type n en comparaison à une couche adjacente (72b ; 72c, 72e ; 72f) de matériau semi-conducteur à dopage de type n.

2. Dispositif électroluminescent (70) selon la revendication 1, dans lequel les contacts anodiques et cathodiques (76, 77) sont dans une configuration étagée.

3. Dispositif électroluminescent (70) selon la revendication 1, dans lequel le matériau semi-conducteur à dopage de type n comprend un matériau semi-conducteur III/V à dopage de type n, un matériau semi-conducteur II/VI à dopage de type n ou un matériau semi-conducteur du groupe IV à dopage de type n.

4. Dispositif électroluminescent (70) selon la revendication 1, dans lequel les ensembles en couches de type p (71) comprennent une pluralité de couches (71 a, 71 b, 71 c ; 71 d, 71 e, 71 f) de matériau semi-conducteur à dopage de type p et dans lequel une couche (71 b, 71e) de matériau semi-conducteur à dopage de type p a un niveau plus élevé de dopant de type p en comparaison à une couche adjacente (71 a, 71 c ; 71 d, 71 f) de matériau semi-conducteur à dopage de type p.

5. Dispositif électroluminescent (70) selon la revendication 4, dans lequel le matériau semi-conducteur à dopage de type p comprend un matériau semi-conducteur III/V à dopage de type p, un matériau semi-conducteur II/VI à dopage de type p ou un matériau semi-conducteur du groupe IV à dopage de type p.

6. Dispositif électroluminescent (70) selon la revendication 5, dans lequel les couches actives électroluminescentes (73) comprennent un matériau semi-conducteur III/V intrinsèque, un matériau semi-conducteur II/VI intrinsèque ou un matériau semi-conducteur du groupe IV intrinsèque.

7. Dispositif électroluminescent (70) selon la revendication 6, dans lequel les ensembles en couches de type p (71), les ensembles en couches de type n (72) et les couches actives électroluminescentes (73) sont épitaxiaux.

8. Dispositif électroluminescent (70) selon la revendication 6, dans lequel les couches actives électroluminescentes (73) ont des profils de pic d'émission différents.

9. Dispositif électroluminescent (70) selon la revendication 1, dans lequel chaque ensemble en couches de type n (72) est en communication électrique avec un contact cathodique indépendant (77) et chaque ensemble en couches de type p (71) est en communication électrique avec un contact anodique indépendant (76).

10. Dispositif électroluminescent (70) selon la revendication 1, comprenant en outre une ou plusieurs couches d'arrêt de gravure dans la configuration empilée.

11. Dispositif électroluminescent (70) selon la revendication 10, dans lequel les une ou plusieurs couches d'arrêt de gravure sont positionnées dans un ensemble en couches de type p (71) ou un ensemble en couches de type n (72).

12. Dispositif électroluminescent (70) selon la revendication 1, lequel comprend deux ou plusieurs ensembles de type n (72) alternant avec deux ou plusieurs ensembles de type p (71), les couches actives électroluminescentes (73) étant positionnées entre eux.

13. Dispositif électroluminescent (70) selon la revendication 12, dans lequel les ensembles en couches de type p (71) comprennent chacun trois couches de matériau semi-conducteur à dopage de type p (71 a, 71 b, 71 c ; 71 d, 71 e, 71 f) et les ensembles en couches de type n (72) comprennent chacun jusqu'à trois couches de matériau semi-conducteur à dopage de type n (72c, 72d, 72e).

14. Dispositif électroluminescent (70) selon la revendication 12 ou la revendication 13, dans lequel les couches individuelles de type p (71 a, 71 b, 71 c ; 71 d, 71 e, 71 f) d'un ensemble de type p (71) ont des niveaux différents de dopant de type p.

15. Dispositif électroluminescent (70) selon la revendication 4 ou la revendication 14, dans lequel les couches centrales (71 b, 71e) d'ensembles de type p (71) présentent des niveaux plus élevés de dopant de type p que des couches de type p adjacentes (71 a, 71c ; 71d, 71f).
